# FASCICULE DE BREVET EUROPEEN

(11) **EP 3 406 530 B1**
(45) Date de publication et mention de la délivrance du brevet: **23.04.2025**
(21) Numéro de dépôt: 18171085.6
(22) Date de dépôt: 07.05.2018
(51) Int. Cl.: B64G 1/10, H04B 7/185

(54) **DISPOSITIF DE TRAITEMENT NUMÉRIQUE À CONNECTIVITÉ ET DÉBIT ENTRANT/SORTANT ÉLEVÉ EMBARQUÉ À BORD D'UNE PLATEFORME SPATIALE ET ÉCLATÉ EN ÎLOTS DE TRAITEMENT MODULAIRES MUTUELLEMENT INTERCONNECTÉS ET DISTANTS À L'ÉCHELLE DE LA PLATEFORME**
VORRICHTUNG ZUR DIGITALEN BEARBEITUNG MIT KONNEKTIVITÄT UND HOHEM EINGEHENDEN/AUSGEHENDEN DATENDURCHSATZ AN BORD EINER WELTRAUM-PLATTFORM UND AUFGETEILT IN MODULARE BEARBEITUNGSINSELN, DIE MITEINANDER VERBUNDEN UND FERN VON DER EBENE DER PLATTFORM SIND
DIGITAL PROCESSING DEVICE HAVING HIGH INCOMING/OUTGOING BANDWIDTH AND CONNECTIVITY ON-BOARD A SPACECRAFT BUS AND UNPACKED INTO MODULAR PROCESSING ISLANDS MUTUALLY INTERCONNECTED AND REMOTE ON THE SCALE OF THE BUS

(30) Priorité: 24.05.2017 FR 1700550
(43) Date de publication de la demande: 28.11.2018
(73) Titulaire: THALES, 92400 Courbevoie (FR)
(72) Inventeur: GACHON, Hélène, 31100 Toulouse (FR); VENET, Norbert, 31100 Toulouse (FR)
(74) Mandataire: Atout PI Laplace

(56) Documents cités:
- WO-A1-2016/034883
- US-A- 5 950 965
- US-A1- 2008 289 801

## Description

La présente invention concerne un dispositif de traitement numérique à connectivité et débit entrant/sortant de données élevé, apte à être embarqué à bord d'une plateforme spatiale, notamment celle d'un satellite et présentant une architecture modulaire.

La présente invention concerne également une architecture d'aménagement ou d'implantation dudit dispositif de traitement numérique au sein de la plateforme spatiale, compatible des performances physiques requises du dispositif de traitement numérique et des contraintes physiques, notamment mécaniques, thermiques et de compatibilité électromagnétique, fixées par la plateforme spatiale et par un nombre prédéterminé d'autres équipements fixés sur ladite plateforme spatiale.

Un dispositif de traitement numérique à connectivité et débit entrant/sortant élevé est un processeur entièrement numérique de type calculateur numérique ou un processeur incluant en entrée un ou plusieurs composants CAN de conversion d'un signal analogique vers un signal numérique (ADC en anglais pour Analogue to Digital Converter) et/ou en sortie un ou plusieurs composants CNA de conversion d'un signal numérique vers un signal analogique (DAC en anglais pour Digital to Analogue Converter) et des composants entièrement numériques pour le restant des composantes.

Le dispositif de traitement numérique peut être en particulier un processeur numérique transparent DTP (en anglais Digital Transparent Processor) ayant pour fonction de fournir de la flexibilité en termes de connectivité, canalisation (en anglais channelization) et plan de fréquence. Le processeur numérique transparent DTP n'est pas limité à une application particulière et peut être utilisé autant pour des applications mobiles que des applications de télécommunications dès lors qu'une exigence de flexibilité est demandé au plan de fréquences. En supplément de la flexibilité du plan de fréquences permise par les fonctionnalités de ce processeur, une conception modulaire du processeur est rendue possible dans laquelle la flexibilité est réalisée en fonction de la taille de la matrice de connectivité associée à chaque mission.

De nombreuses architectures modulaires de processeurs numériques de différentes tailles s'agissant de leurs matrices de connectivité ont été décrites dans de nombreux documents. Certaines de ces architectures ont même été développées, testées et qualifiées pour des applications spatiales.

Ces architectures sont décrites par exemple dans les documents suivants :
- un premier document de H. Gachon et al., intitulé « Digital processor for telecommunication payload », publié dans les Proceedings of 2nd ESA workshop on Advanced Flexible Telecom Payloads, April 2012,
- un deuxième document de P. Tabacco et al,intitulé "Development &testing of a proof-of-concept real-time demonstrator representing a wideband Bent-Pipe on board Processor with beam forming", publié dans les proceedings d'un ESA workshop, 2012,
- -un troisième document de N. MacManus et al., intitulé "Digital Beam-forming applicable to C, Ku and Ka bands", publié dans les Proceedings du 3rd ESA Workshop on Advanced Flexible Telecom Payloads, 21-24 March 2016, et
- un quatrième document de H. Gachon et al., intitulé « Spaceflex Digital Transparent Processor For Advanced Flexible Payloads" et publié dans les Proceedings of 3rd ESA Workshop on Advanced Flexible Telecom Payloads,
- la demande de brevet WO 2016/034883 A1 formant un cinquième document.

Toutes ces architectures sont construites à partir de la définition d'un ou plusieurs modules génériques unitaires ou « briques de base », et d'un assemblage modulaire de plusieurs modules unitaires permettant de réaliser des matrices de connectivité de taille variable pouvant aller jusqu'à une centaine d'accès. Les modules unitaires de cet assemblage sont regroupés entre eux de manière compacte et locale. Pour cet assemblage, des liaisons optiques de longueurs courtes ont été développées pour résoudre la problématique de connexion de fond de panier des équipements liée aux limitations des liaisons classiques par câbles électriques en termes de faiblesse de débit de transmission et/ou d'encombrement excessif.

Toutefois, face aux exigences d'une connectivité croissante en termes d'un nombre d'accès de la matrice de connectivité de plus en plus grand et/ou d'une bande traitée par accès de plus en plus grande, i.e. d'une capacité totale plus grande, ce qui se traduit par un débit plus grand à router sur une distance plus importante, une masse, un encombrement, et une puissance thermique à dissiper de l'équipement plus importants, les architectures actuelles d'équipement conduisent à des incompatibilités d'aménagement mécanique, thermique et de compatibilité électromagnétique dudit équipement vis-à-vis de la plateforme spatiale et des équipements restants à intégrer sur la même plateforme.

Le problème technique est d'augmenter le nombre et/ou le débit de ports d'entrée et de ports de sortie et/ou la connectivité entrée/sortie d'un dispositif de traitement numérique et, en lien avec l'augmentation créée d'encombrement, de masse et de dissipation thermique du dispositif, d'augmenter la flexibilité d'aménagement dudit dispositif de traitement au sein d'une plateforme spatiale prédéterminée pour le rendre compatible des contraintes physiques, notamment mécaniques, thermiques et de compatibilité électromagnétique, fixées par ladite plateforme spatiale et par un nombre prédéterminé d'autres équipements fixés sur la même plateforme.

Le deuxième problème technique est de rendre minimale l'augmentation de masse engendrée par la flexibilité d'aménagement apportée au dispositif vis-à-vis de la plateforme spatiale.

A cet effet, l'invention a pour objet un dispositif de traitement numérique, destiné à être embarqué à bord d'une plateforme spatiale, comprenant une pluralité de ports d'entrée et de sortie, et ayant une architecture modulaire multi-modules fondée sur l'utilisation d'un ou plusieurs types de modules élémentaires de base et sur une matrice de connectivité de taille prédéterminée, le dispositif de traitement numérique comprenant : une première pluralité de ports d'entrée, une deuxième pluralité de ports de sortie, et une troisième pluralité d'au moins quatre modules élémentaires de base. Le dispositif de traitement numérique est caractérisé en ce que : la troisième pluralité des modules élémentaires est éclatée suivant un partitionnement d'au moins deux sous-ensembles de module(s), chaque sous-ensemble de module(s) comportant un ou plusieurs module(s) élémentaire(s) et une structure mécanique monobloc différente dans laquelle sont intégrés le ou les modules élémentaires; et au moins deux sous-ensembles de modules du partitionnement de la troisième pluralité sont des sous-ensembles d'au moins deux modules chacun définissant un ilot différent de modules, et le dispositif de traitement numérique comporte un harnais de liaisons optiques d'interconnexion des sous-ensembles de modules entre eux dont les longueurs d'interconnexion sont compatibles de cheminements d'interconnexion entre deux ilots interconnectés, lesdites longueurs d'interconnexion étant agencées pour éviter par contournement un ou plusieurs équipements externes au dispositif de traitement numérique, aménagés sur la plateforme spatiale et interposés entre les deux ilots interconnectés, et/ou pour répartir au moins deux ilots interconnectés sur deux zones d'échanges thermiques de la plateforme spatiale séparées par une distance de séparation à l'échelle de la taille de la plateforme, au moins une longueur d'interconnexion externe du harnais optique entre deux ilots de modules est comprise entre 1 mètre et 50 mètres, de préférence entre 1 et 7 mètres.

Suivant des modes particuliers de réalisation, le dispositif de traitement numérique comprend l'une ou plusieurs des caractéristiques suivantes :
- la troisième pluralité des modules élémentaires est éclatée suivant un partitionnement d'au moins deux sous-ensembles de module(s), le partitionnement contenant au moins deux ilots, le partitionnement étant déterminé de sorte à répartir la masse et la puissance thermique du dispositif de traitement numérique sur au moins deux zones d'échanges thermiques de la plateforme spatiale nettement séparées par une distance de séparation à l'échelle de la taille de la plateforme spatiale ;
- la troisième pluralité des modules élémentaires est éclatée suivant un partitionnement contenant seulement des ilots ;
- le débit par port d'entrée et par port de sortie est élevé et compris entre 6 Mb/s et 100 Mb/s, et/ou le nombre ne de ports d'entrée est compris entre 8 et 200, et le nombre ns de ports de sortie est compris entre 8 et 200, et/ou le nombre de module est compris entre 2 et 100, et/ou le nombre d'ilots est compris entre 1 et 10 ;
- le dispositif de traitement numérique comprend au moins deux types génériques de modules élémentaires de base, ou un seul type générique de modules élémentaires de base ;
- le dispositif de traitement numérique est un processeur compris dans l'ensemble formé par les processeurs entièrement numériques de type calculateur numérique, et les processeur incluant en entrée un ou plusieurs composants CAN de conversion d'un signal analogique vers un signal numérique et/ou en sortie un ou plusieurs composants CNA de conversion d'un signal numérique vers un signal analogique et des composants entièrement numériques pour le restant des composantes ;
- le dispositif de traitement numérique est configuré pour être un processeur numérique transparent DTP ayant pour fonction de fournir de la flexibilité en termes de connectivité, canalisation et plan de fréquence ;
- le harnais de liaisons optiques externes d'interconnexion des ilots est formés par des fibres optiques séparées ou regroupées par ruban d'une dizaine de liens optiques.

L'invention a également pour objet une plateforme spatiale aménagée comprenant un dispositif de traitement numérique tel que défini ci-dessus.

Suivant des modes particuliers de réalisation, la plateforme aménagée comprend l'une ou plusieurs des caractéristiques suivantes :
- la plateforme spatiale comprend un premier panneau d'échange thermique et un deuxième panneau d'échange thermique, séparées entre eux par un ou plusieurs planchers, et dans laquelle les ilots du dispositif de traitement numérique sont répartis sur le premier panneau d'échange thermique et le deuxième panneau d'échange thermique, et sont séparés par un harnais d'interconnexion optique dont le cheminement traverse au moins un plancher sur sa longueur.

L'invention sera mieux comprise à la lecture de la description de plusieurs formes de réalisation qui va suivre, donnée uniquement à titre d'exemple et faite en se référant aux dessins sur lesquels :
- la Figure 1 est une vue d'un exemple d'architecture modulaire d'un dispositif de traitement numérique réalisant ici typiquement les fonctionnalités d'un processeur numérique transparent de satellite ;
- la Figure 2 est une vue physique du dispositif de traitement numérique de Figure 1 éclatés en ilots compacts mutuellement distants de modules, les ilots étant reliés entre eux par un harnais de liaisons optiques externes,
- la Figure 3 est une vue de l'aménagement du dispositif de traitement des Figures 1 et 2 éclatés en ilots et des cheminements du harnais des liaisons optiques externes reliant les ilots entre eux.

Un premier concept sous-jacent de l'invention est de répartir la masse et la puissance thermique à dissiper du dispositif de traitement numérique sur plusieurs zones de support et de régulation thermique de la plateforme spatiale, séparées entre elles par des distances éventuellement importantes, tout en garantissant le respect des exigences de connectivité et de débit. Cette répartition de masse et de puissance thermique est réalisée en éclatant le dispositif de traitement numérique classique initial, concentré physiquement en une même zone spatiale et intégré en un même bloc mécanique, et ses fonctionnalités associées, en plusieurs dispositifs-ilots avec leurs sous-ensembles fonctionnels respectifs, sans contrainte sur le nombre d'ilots, ni leurs distances d'espacement, ni leur positionnement sur la plateforme spatiale, chaque dispositif-ilot étant intégré dans un bloc mécanique différent.

Un deuxième concept sous-jacent de l'invention est de remplacer les harnais électriques de connexion entre les différents ilots par des harnais optiques externes.

Ainsi, les contraintes d'aménagement du dispositif de traitement numérique sur la plateforme spatiale sont résolues en répartissant la ou les fonctions à réaliser sur plusieurs zones de la plateforme spatiale pour ne pas en concentrer la masse et la dissipation, et cela sans contrainte de distance entre les différents blocs, ni de nombre de blocs.

Ainsi, l'architecture du dispositif de traitement numérique selon l'invention permet de lever le verrou de l'aménagement sur la plateforme spatiale, en permettant de réaliser la fonction du dispositif de traitement numérique, non plus en un seul équipement au sens un seul ensemble mécanique intégré monobloc, mais en plusieurs blocs-ilots mécaniques, sans contrainte ni sur le nombre de blocs-ilots, ni sur les distances de séparation de ces blocs-ilots, et sans impact sur la performance, c'est-à-dire sans modifier la performance RF du dispositif de traitement numérique et sans sur-dimensionner la plateforme ou les autres équipements de charge utile embarqués sur la plateforme spatiale.

Ainsi, l'utilisation de liaisons optiques externes permet d'éclater le dispositif de traitement numérique mécaniquement monobloc en plusieurs sous-ensembles monoblocs ou blocs-ilots et d'interconnecter lesdits blocs-ilots au travers d'interfaces de cartes numériques d'interconnexion externe pourvues à cet effet. Ces liaisons optiques externes peuvent mettre à profit les développements, déjà effectués pour réaliser la connectique interne à un équipement au sens d'une fonction réalisée en un même ensemble mécanique, et décrit dans l'article de N. Venet et al., intitulé « High-Throughput Optical Inter-Board Interconnects for Next-Generation On-board Digital Transparent Processors » et publié dans les Proceedings de l'ISCO 2014 (International Conference on Space Optics), Tenerife, Canary Islands, Spain, 7-10 October 2014.

Les autres avantages sont une drastique réduction de la masse et du volume des harnais, ainsi que l'amélioration des performances EMC.

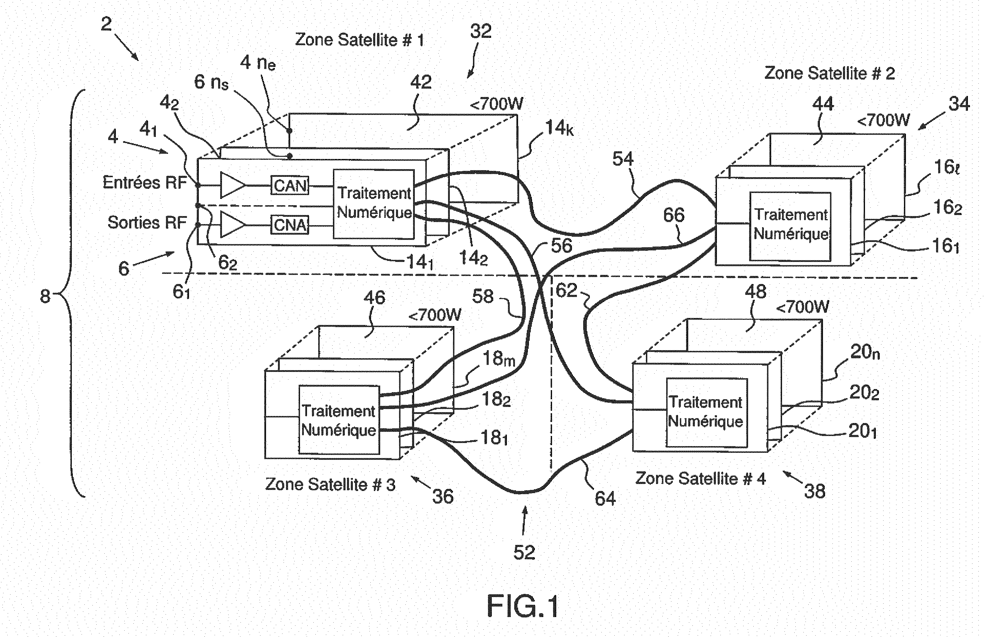

Suivant la Figure 1 et un exemple de mode de réalisation d'un dispositif de traitement numérique selon l'invention, un dispositif de traitement numérique 2 comprend une première pluralité 4 de ports d'entrée 4₁, 4₂, ..., 4ₙₑ, une deuxième pluralité 6 de ports de sortie 6₁, 6₂, ..., 6ₙₛ, et une troisième pluralité 8 d'au moins quatre modules élémentaires de base.

Le dispositif de traitement numérique 2 est configuré pour être embarqué à bord d'une plateforme spatiale, ici une plateforme de satellite, non représentée sur la Figure 1.

Le dispositif de traitement numérique 2 présente une connectivité entrée/sortie élevée, fonction de la taille de la matrice de connectivité qui lui est associée.

Le dispositif de traitement numérique 2 comporte une architecture modulaire multi-modules fondée sur l'utilisation de plusieurs types génériques de modules élémentaires de base, ici deux types génériques 10 et 12 pour simplifier, sur plusieurs fonctionnalités prédéterminées, et sur une matrice de connectivité de taille prédéterminée.

Ici, le dispositif de traitement numérique 2 est de manière particulière un processeur numérique transparent DTP (en anglais Digital Transparent Processor) ayant pour fonctionnalités de fournir de la flexibilité en termes de connectivité, canalisation et plan de fréquence.

Ici et de manière simplifiée, le dispositif de traitement numérique 2 comporte un premier type générique 10 de modules élémentaires de base identiques 14₁, 14₂..., 14ₖ, k étant un entier supérieur ou égal à 3, ayant chacun en entrée plusieurs composants CAN de conversion d'un signal analogique vers un signal numérique et en sortie plusieurs composants CNA de conversion d'un signal numérique vers un signal analogique, mis en parallèle et connectés respectivement aux ports d'entrée 4₁, 4₂, ..., 4ₙₑ et aux ports de sortie 6₁, 6₂, ..., 6ₙₛ, et ayant chacun un ou plusieurs composants numériques 18 pour le restant des composants. Les modules élémentaires de base 14₁, 14₂..., 14ₖ sont ici des modules de gestion des entrées/sorties RF et de leurs conversions analogique/numérique ou numérique/analogique.

Ici et de manière simplifiée, le dispositif de traitement numérique 2 comporte un deuxième type générique 12 de modules élémentaires de base identiques 16₁, 16₂, ...16₁, 18₁, 18₁, 18₂, ..., 18ₘ, 20₁, 20₂, ..., 20ₙ, l, m, et n étant des entiers chacun supérieur ou égal à 3, ayant chacun des composants numériques. Les modules élémentaires de base identiques 16₁, 16₂, ...16ₗ, 18₁, 18₁, 18₂, ..., 18ₘ, 20₁, 20₂, ..., 20ₙ sont ici des modules de commutation et de routage.

La troisième pluralité 8 des modules élémentaires est partitionnée ici en quatre sous-ensembles 32, 34, 36, 38.

Le premier sous-ensemble 32 comporte les k modules élémentaires 14₁, 14₂..., 14ₖ de premier type 10 qui sont regroupés et intégrés dans une première structure mécanique monobloc 42.

Le deuxième sous-ensemble 34 comporte les l modules élémentaires 16₁, 16₂, ...16ₗ de deuxième type 12 qui sont regroupés et intégrés dans une deuxième structure mécanique monobloc 44.

Le troisième sous-ensemble 36 comporte les m modules élémentaires 18₁, 18₁, 18₂, ..., 18ₘ de deuxième type 12 qui sont regroupés et intégrés dans une troisième structure mécanique monobloc 46.

Le quatrième sous-ensemble 38 comporte les n modules élémentaires 20₁, 20₂, ..., 20ₙ de deuxième type 12 qui sont regroupés et intégrés dans une quatrième structure mécanique monobloc 48.

Un ilot de modules étant défini comme un sous-ensemble d'au moins deux modules intégrés dans une même structure mécanique monobloc, les quatre sous-ensembles 32, 34, 36, 38 forment ici quatre ilots.

Le dispositif de traitement numérique 2 comporte un harnais 52 de liaisons optiques 54, 56, 58, 62, 64, 66, d'interconnexion externe des sous-ensembles de modules 32, 34, 36, 38, entre eux.

Les longueurs d'interconnexion des liaisons optiques externes sont compatibles de cheminements d'interconnexion entre deux ilots interconnectés quelconques. Elles permettent d'éviter par contournement un ou plusieurs équipements externes au dispositif de traitement numérique, aménagés sur la plateforme spatiale et interposés entre les deux ilots interconnectés, ou permettent de répartir au moins deux ilots interconnectés sur deux zones d'échanges thermiques de la plateforme spatiale nettement séparées par une distance de séparation à l'échelle de la taille de la plateforme.

Au moins une longueur d'interconnexion externe du harnais optique 52 entre deux ilots de modules est comprise entre 1 mètre et 50 mètres, de préférence entre 1 et 7 mètres, typiquement 4 mètres.

Ici, le dispositif de traitement numérique 2 est supposé devoir dissiper une puissance thermique de plus de 2 kW et inférieure à 3 kW.

Le dispositif de traitement numérique 2 est éclaté en les quatre sous-ensembles 32, 34, 36, 38, formant ilots et répartis respectivement sur une première zone, une deuxième zone, une troisième zone et une quatrième zone de la plateforme spatiale.

Les quatre sous-ensembles 32, 34, 36, 38 sont configurés pour dissiper chacun une puissance thermique inférieure à 700 W, typiquement considéré comme un seuil de puissance thermique à ne pas dépasser sur chacune des zones de la plateforme spatiale pour garantir le fonctionnement efficace de la gestion thermique de la plateforme.

La connectique entre les quatre sous-ensembles 32, 34, 36, 38 représente un nombre de plus de 2200 liaisons à router à travers la plateforme spatiale.

Un aménagement classique de deux sous-ensembles, espacés de quelques décimètres et interconnectés par un harnais de 200 liaisons électriques, conduisant à une masse de ce harnais de l'ordre de 64kg, l'utilisation d'un harnais électrique est rédhibitoire dans le cas d'un routage de 2200 liaisons. En outre, l'utilisation d'un harnais électrique limite la longueur des liaisons à 1.5m, et ne garantit ni le respect des exigences des performances du dispositif de traitement numérique, ni le respect des contraintes de routage de la charge utile au travers des autres équipements.

De manière avantageuse un aménagement, utilisant un harnais optique, réduit le bilan de masse à seulement 5kg à longueur égale et débit de données égal des 200 liaisons électriques considérées dans le cas classique, sans limiter la longueur des liens qui peuvent facilement dépasser les trois mètres et offrir le maximum de flexibilité possible sur l'aménagement.

En outre, les fibres optiques peuvent être regroupées par rubans d'une dizaine de liens, un ruban d'une dizaine de liens étant équivalent en termes d'encombrement à un câble électrique d'un lien unique. Cela simplifie d'autant la complexité de routage et lève le verrou de la capacité de traitement sans impact sur le nombre de liens à router : à encombrement équivalent, la capacité de traitement est multipliée par 20 par rapport à la capacité de traitement actuelle.

Les liaisons optiques externes permettent de garantir des liaisons de plusieurs mètres avec très peu de perte, là où des liens électriques sont limités en longueur et en débit transmis. Par ailleurs, les liaisons optiques sont vingt fois moins massives au Gb/s par mètre linéaire que les câbles électriques actuellement disponibles. De plus l'utilisation de liaisons optiques externes est sans incidence vis à vis des contraintes EMC de compatibilité électromagnétiques.

De manière générale, un dispositif de traitement numérique selon l'invention, destiné à être embarqué à bord d'une plateforme spatiale et à connectivité entrée/sortie élevée, comporte une architecture modulaire, cette architecture modulaire étant fondée sur l'utilisation d'un ou plusieurs types génériques de modules élémentaires de base, sur une ou plusieurs fonctionnalité prédéterminée(s) et sur une matrice de connectivité de taille prédéterminée.

Le dispositif de traitement numérique comprend une première pluralité de ports d'entrée, une deuxième pluralité de ports de sortie, et une troisième pluralité d'au moins quatre modules élémentaires de base.

La troisième pluralité des modules élémentaires est partitionnée en au moins deux sous-ensembles de module(s). Chaque sous-ensemble de module(s) comporte un ou plusieurs module(s) élémentaire(s) et une structure mécanique monobloc différente dans laquelle sont intégrés le ou lesdits modules élémentaires.

Au moins deux sous-ensembles de modules du partitionnement de la troisième pluralité sont chacun un sous-ensemble d'au moins deux modules définissant un ilot différent de modules.

Le dispositif de traitement numérique selon l'invention comporte un harnais de liaisons optiques externes d'interconnexion des sous-ensembles de modules entre eux.

Les longueurs d'interconnexion des liaisons optiques externes sont compatibles de cheminements d'interconnexion entre ilots interconnectés qui permettent d'éviter par contournement un ou plusieurs équipements externes au dispositif de traitement numérique, aménagés sur la plateforme spatiale et interposés entre les deux ilots interconnectés, ou qui permettent de répartir au moins deux ilots interconnectés sur deux zones d'échanges thermiques de la plateforme spatiale nettement séparées par une distance de séparation à l'échelle de la taille de la plateforme.

De manière particulière, la troisième pluralité des modules élémentaires est éclatée suivant un partitionnement d'au moins deux sous-ensembles de module(s) contenant au moins deux ilots. Le partitionnement est déterminé de sorte à répartir la masse et la puissance thermique du dispositif de traitement sur au moins deux zones d'échanges thermiques de la plateforme spatiale nettement séparées par une distance de séparation à l'échelle de la taille de la plateforme spatiale.

En variante, la troisième pluralité des modules élémentaires est partitionnée en un partitionnement contenant seulement des ilots.

Le débit par port d'entrée et par port de sortie est élevé et compris entre 6 Mb/s et 100 Mb/s.

Le nombre de port d'entrée est compris entre 8 et 200, et le nombre de ports de sortie est compris entre 8 et 200.

Le nombre de module est compris entre 2 et 100, et/ou le nombre d'ilots est compris entre 1 et 10.

De manière particulière, le dispositif de traitement numérique comprend au moins deux types génériques de modules élémentaires de base, ou un seul type générique de modules élémentaires de base.

De manière générale, le dispositif de traitement numérique est un processeur compris dans l'ensemble formé par les processeurs entièrement numérique de type calculateur numérique, et les processeurs incluant en entrée un ou plusieurs composants CAN de conversion d'un signal analogique vers un signal numérique et/ou en sortie un ou plusieurs composants CNA de conversion d'un signal numérique vers un signal analogique et des composants entièrement numériques pour le restant des composantes.

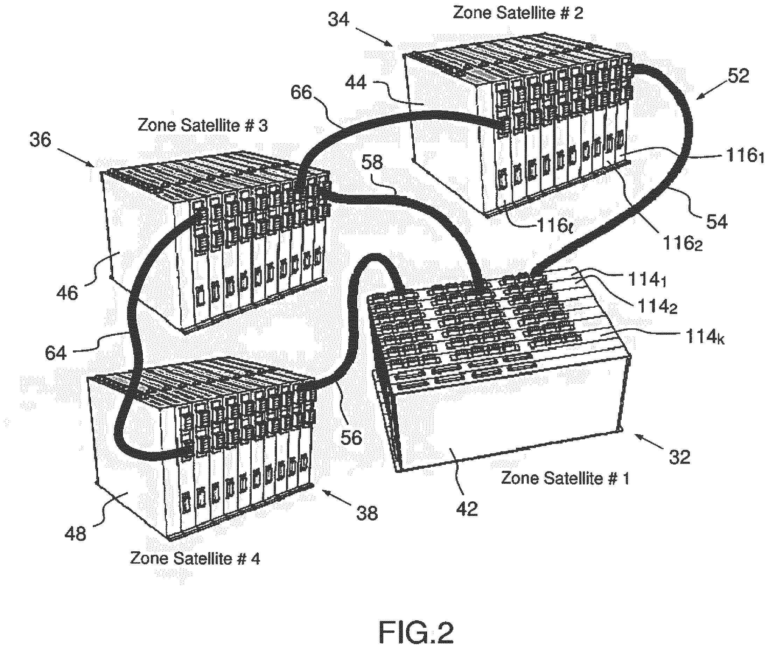

Suivant la Figure 2, un exemple des première, deuxième, troisième, quatrième structures mécaniques monobloc 42, 44, 46, 48, associées respectivement aux première, deuxième, troisième, quatrième sous-ensembles modulaires 32, 34, 36, 38 du dispositif de traitement numérique 2 de la Figure est illustré de manière détaillée.

Chaque structure mécanique monobloc 42, 44, 46, 48 est constituée par des boitiers métalliques abritant sous forme de tranches individuelles les modules correspondant et vissées entre eux côte à côte.

Par exemple, les k modules élémentaires 14₁, 14₂..., 14ₖ de premier type 10 du premier sous-ensemble 32 sont intégrés chacun dans des boitiers métalliques 114₁, 114₂..., 114ₖ respectifs formant k tranches étanches. Les boitiers métalliques 114₁, 114₂..., 114ₖ sont alignés côte à côte et fixées entre eux, par exemple par vissage, pour former la première structure mécanique monobloc 42.

Par exemple, les l modules élémentaires 16₁, 16₂..., 16ₖ de deuxième type 12 du deuxième sous-ensemble 34 sont intégrés chacun dans des boitiers métalliques 116₁, 116₂..., 116ₗ formant l tranches étanches. Les boitiers métalliques 116₁, 116₂..., 116ₗ sont alignés côte à côte et fixées entre eux, par exemple par vissage, pour former la deuxième structure mécanique monobloc 44.

Les troisième et quatrième structures mécaniques monobloc 46, 48 sont réalisées et agencées de manière analogue à la deuxième structure monobloc 44, seuls les entiers m, n pouvant différer de l'entier l.

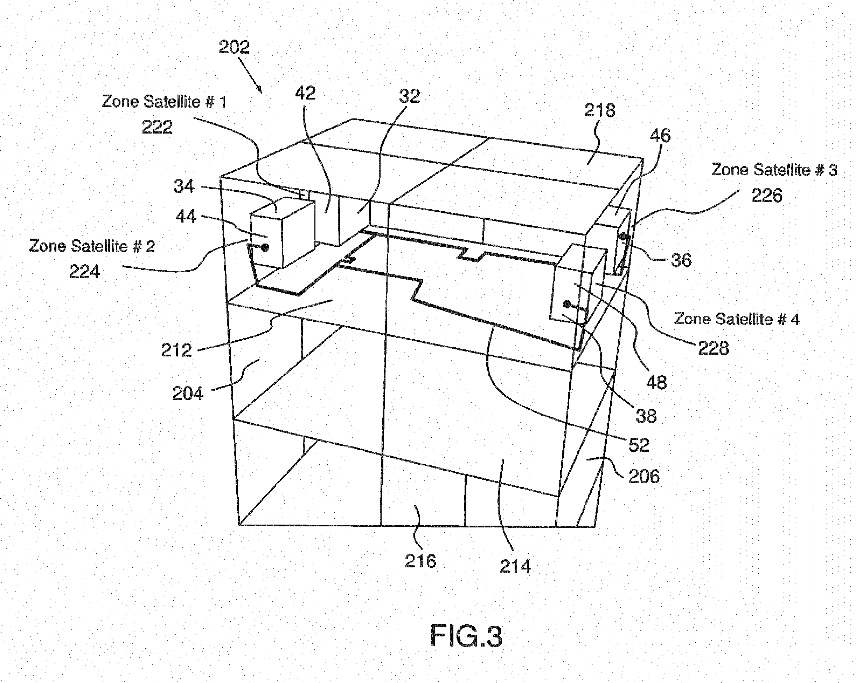

Suivant la Figure 3, une plateforme spatiale aménagée 202 comprend le dispositif de traitement numérique 2 tel que décrit ci-dessus et un ensemble d'équipements de charge utile, non représentée sur la Figure 3.

La plateforme spatiale aménagée 202 comprend un premier panneau d'échange thermique 204 et un deuxième panneau d'échange thermique 206, séparées entre eux par un ou plusieurs planchers 212, 214.

La plateforme spatiale aménagée 202 comprend également ici un panneau intermédiaire 216, formant un raidisseur orienté verticalement sur la Figure 3 et interposé entre les premier et deuxième panneaux d'échange thermique 204, 206.

La plateforme spatiale aménagée 202 comprend également ici un panneau 218 de liaison d'extrémité des premier et deuxième panneaux d'échange thermique 212, 214, illustré dans le haut de la Figure 3.

Les ilots du dispositif de traitement numérique, c'est-à-dire les premier, deuxième, troisième, quatrième sous-ensembles modulaires 32, 34, 36, 38 sont répartis sur le premier panneau d'échange thermique 204 et le deuxième panneau d'échange thermique 206, et sont séparés par le harnais d'interconnexion optique 52 dont le cheminement traverse ici un plancher sur sa longueur, ici le premier plancher 212.

En variante, le cheminement traverse plusieurs planchers.

Ici, les première et deuxième structures mécaniques monobloc 42, 44 sont disposés sur la face intérieure du premier panneau d'échange thermique 204 en une première « zone satellite » 222 et une deuxième « zone satellite » 224 respectives. Les troisième et quatrième structures mécaniques monobloc 46, 48 sont disposés sur la face intérieure du deuxième panneau d'échange thermique 206 en une troisième « zone satellite » 226 et une quatrième « zone satellite » 228 respectivement.

Dans cette configuration, la longueur des liaisons du harnais 52 séparant le premier sous-ensemble modulaire 32 et les troisième, quatrième sous-ensembles modulaires 36, 38 dépasse 4 mètres. En plus de la distance géométrique résultant des emplacements des sous-ensembles modulaires, le harnais peut être contraint dans le routage d'emprunter des trous, prédéterminés voire normalisés, de passage au travers des panneaux planchers et/ou des panneaux formant des murs raidisseurs.

Ainsi, il est possible d'implanter les différentes structures mécaniques monobloc du dispositif de traitement numérique de façon à ce que l'implantation soit compatible des contraintes d'aménagement et de dissipation thermique d'une plate-forme.

Ainsi une fabrication et des tests indépendants peuvent être effectués séparément sur les différents ilots. Ainsi, un test de la fonction complète du dispositif de traitement numérique est rendu possible.

Les différents ilots modulaires sont montés de manière indépendante sur les panneaux du satellite puis connectés par des liens optiques, comme s'il s'agissait de différents équipements de la charge utile.

## Revendications

1. Dispositif de traitement numérique, destiné à être embarqué à bord d'une plateforme spatiale, comprenant une pluralité de ports d'entrée et de sortie, et ayant une architecture modulaire multi-modules fondée sur l'utilisation d'un ou plusieurs types (10, 12) de modules élémentaires de base, et sur une matrice de connectivité de taille prédéterminée, ledit dispositif comprenant
. - une première pluralité (4) de ports d'entrée (4₁, 4₂, ..., 4ₙₑ),
. - une deuxième pluralité (6) de ports de sortie (6₁, 6₂, ..., 6ₙₛ), et
. -une troisième pluralité (8) d'au moins quatre modules élémentaires de base (14₁, 14₂..., 14ₖ; 16₁, 16₂, ...16ₗ; 18₁, 18₁, 18₂, ..., 18ₘ; 20₁, 20₂, ..., 20ₙ),
**caractérisé en ce que**
la troisième pluralité (8) des modules élémentaires est éclatée suivant un partitionnement d'au moins deux sous-ensembles (32 ; 34 ; 36 ; 38) de module(s)(14₁, 14₂..., 14ₖ;16₁, 16₂, ...16ₗ; 18₁, 18₁, 18₂, ..., 18ₘ; 20₁, 20₂, ..., 20ₙ), chaque sous-ensemble (32 ; 34 ; 36 ; 38) de module(s) comportant un ou plusieurs module(s) élémentaire(s)(14₁, 14₂..., 14ₖ; 16₁, 16₂, ...16ₗ; 18₁, 18₁, 18₂, ..., 18ₘ; 20₁, 20₂, ..., 20ₙ) et une structure mécanique monobloc (42, 44, 46, 48) différente dans laquelle sont intégrés le ou les modules élémentaires (14₁, 14₂..., 14ₖ; 16₁, 16₂, ...16ₗ; 18₁, 18₁, 18₂, ..., 18ₘ; 20₁, 20₂, ..., 20ₙ), et
au moins deux sous-ensembles (32, 34, 36, 38) de modules du partitionnement de la troisième pluralité (8) sont des sous-ensembles d'au moins deux modules chacun définissant un ilot différent de modules, et
le dispositif de traitement numérique comporte un harnais (52) de liaisons optiques (54, 56, 58, 62, 64, 66) d'interconnexion des sous-ensembles (32, 34, 36, 38) de modules entre eux dont les longueurs d'interconnexion sont compatibles de cheminements d'interconnexion entre deux ilots interconnectés (32, 34, 36, 38), lesdites longueurs d'interconnexion étant agencées pour éviter par contournement un ou plusieurs équipements externes au dispositif de traitement numérique, aménagés sur la plateforme spatiale et interposés entre les deux ilots interconnectés, et/ou pour répartir au moins deux ilots interconnectés sur deux zones d'échanges thermiques de la plateforme spatiale séparées par une distance de séparation à l'échelle de la taille de la plateforme, au moins une longueur d'interconnexion externe du harnais optique (52) entre deux ilots de modules est comprise entre 1 mètre et 50 mètres, de préférence entre 1 et 7 mètres.

2. Dispositif de traitement numérique selon la revendication 1 dans lequel
la troisième pluralité (8) des modules élémentaires est éclatée suivant un partitionnement d'au moins deux sous-ensembles de module(s) (32, 34, 36, 38), le partitionnement contenant au moins deux ilots (32, 34, 36, 38),
le partitionnement étant agencé pour répartir la masse et la puissance thermique du dispositif de traitement numérique sur au moins deux zones d'échanges thermiques (222, 224, 226, 228) de la plateforme spatiale (202) séparées par une distance de séparation à l'échelle de la taille de la plateforme spatiale (202).

3. Dispositif de traitement numérique selon l'une quelconque des revendications 1 à 2 dans lequel
la troisième pluralité (8) des modules élémentaires est éclatée suivant un partitionnement contenant seulement des ilots (32,34, 36, 38).

4. Dispositif de traitement numérique selon l'une quelconque des revendications 1 à 2, dans lequel
le débit des ports d'entrée et des ports de sortie sont compris entre 6 Mb/s et 100 Mb/s, et/ou
le nombre de ports d'entrée est compris entre 8 et 200, et
le nombre de ports de sortie est compris entre 8 et 200, et/ou
le nombre de module est compris entre 2 et 100, et/ou
le nombre d'ilots est compris entre 1 et 10.

## Patentansprüche

1. Digitale Verarbeitungsvorrichtung, die dazu bestimmt ist, an Bord einer Raumstation gebracht zu werden, die eine Vielzahl von Eingangs- und Ausgangsanschlüssen umfasst, und eine modulare Mehrfachmodul-Architektur aufweist, die auf der Verwendung einer oder mehrerer Arten (10, 12) elementarer Grundmodule und auf einer Konnektivitätsmatrix mit vorbestimmter Größe basiert, wobei die Vorrichtung Folgendes umfasst:
. - eine erste Vielzahl (4) von Eingangsanschlüssen (4₁, 4₂, ..., 4ₙₑ),
. - eine zweite Vielzahl (6) von Ausgangsanschlüssen (6₁, 6₂, ..., 6ₙₛ), und
. - eine dritte Vielzahl (8) von mindestens vier elementaren Grundmodulen (14₁, 14₂..., 14ₖ; 16₁, 16₂, ...16ₗ; 18₁, 18₁, 18₂, ..., 18ₘ; 20₁, 20₂, ..., 20ₙ),
**dadurch gekennzeichnet, dass**
die dritte Vielzahl (8) der elementaren Module gemäß einer Unterteilung von mindestens zwei Untergruppen (32; 34; 36; 38) eines Moduls (von Modulen) (14₁, 14₂..., 14ₖ; 16₁, 16₂, ...16ₗ; 18₁, 18₁, 18₂, ..., 18ₘ; 20₁, 20₂, ..., 20ₙ) aufgeteilt ist, wobei jede Untergruppe (32; 34; 36; 38) eines Moduls (von Modulen) ein oder mehrere elementare Module (14₁, 14₂..., 14ₖ; 16₁, 16₂, ...16ₗ; 18₁, 18₁, 18₂, ..., 18ₘ; 20₁, 20₂, ..., 20ₙ) und eine verschiedene mechanische Monoblockstruktur (42, 44, 46, 48) umfasst, in der das eine r die mehreren elementaren Module (14₁, 14₂..., 14ₖ; 16₁, 16₂, ...16ₗ; 18₁, 18₁, 18₂, ..., 18ₘ; 20₁, 20₂, ..., 20ₙ) integriert sind; und
mindestens zwei Untergruppen (32, 34, 36, 38) von Modulen der Unterteilung der dritten Vielzahl (8) Untergruppen von mindestens zwei Modulen sind, wobei jedes eine verschiedene Insel von Modulen definiert, und
die digitale Verarbeitungsvorrichtung einen Kabelbaum (52) von optischen Kabelstrecken (54, 56, 58, 62, 64, 66) zum Verbinden der Untergruppen (32, 34, 36, 38) von Modulen untereinander aufweist, deren Verbindungslängen kompatibel mit Verbindungswegen zwischen zwei verbundenen Inseln (32, 34, 36, 38) sind, wobei die Verbindungslängen derart angeordnet sind, dass durch Umgehen eine oder mehrere Ausrüstungen außerhalb der digitalen Verarbeitungsvorrichtung vermieden werden, die auf der Raumstation installiert und zwischen den beiden verbundenen Inseln zwischengeschaltet sind, und/oder dass mindestens zwei verbundene Inseln auf zwei Wärmetauschzonen der Raumstation verteilt werden, die um einen Trennabstand im Maßstab der Größe der Station getrennt sind, wobei mindestens eine externe Verbindungslänge des optischen Kabelbaums (52) zwischen zwei Modulinseln zwischen 1 Meter und 50 Metern, vorzugsweise zwischen 1 und 7 Metern beträgt.

2. Digitale Verarbeitungsvorrichtung nach Anspruch 1, wobei
die dritte Vielzahl (8) der elementaren Module gemäß einer Unterteilung von mindestens zwei Untergruppen eines Moduls (von Modulen) (32; 34; 36; 38) aufgeteilt ist, wobei die Unterteilung mindestens zwei Inseln (32, 34, 36, 38) enthält,
die Unterteilung so angeordnet ist, dass die Masse und die Wärmeleistung der digitalen Verarbeitungsvorrichtung auf mindestens zwei Wärmetauschzonen (222, 224, 226, 228) der Raumstation (202), die um einen Trennabstand im Maßstab der Größe der Raumstation (202) getrennt sind, verteilt werden.

3. Digitale Verarbeitungsvorrichtung nach einem der Ansprüche 1 bis 2, wobei
die dritte Vielzahl (8) der elementaren Module gemäß einer Unterteilung aufgeteilt ist, die nur Inseln (32, 34, 36, 38) enthält.

4. Digitale Verarbeitungsvorrichtung nach einem der Ansprüche 1 bis 2, wobei
die Übertragungsgeschwindigkeit der Eingangsanschlüsse und der Ausgangsanschlüsse zwischen 6 Mb/s und 100 Mb/s liegen, und/oder
die Anzahl von Eingangsanschlüssen zwischen 8 und 200 liegt, und
die Anzahl von Ausgangsanschlüssen zwischen 8 und 200 liegt, und/oder
die Anzahl von Modulen zwischen 2 und 100 liegt, und/oder
die Anzahl von Inseln zwischen 1 und 10 liegt.

## Claims

1. A digital processing device, intended to be embedded aboard a space platform, comprising a plurality of input and output ports, and having a multi-module modular architecture based on the use of one or more types (10, 12) of basic elementary modules, and on a connectivity matrix of predetermined size, said device comprising
. - a first plurality (4) of input ports (4₁, 4₂, ..., 4ₙₑ),
. - a second plurality (6) of output ports (6₁, 6₂, ..., 6ₙₛ), and
. - a third plurality (8) of at least four basic elementary modules (14₁, 14₂..., 14ₖ; 16₁, 16₂, ...16ₗ; 18₁, 18₁, 18₂, ..., 18ₘ; 20₁, 20₂, ..., 20ₙ),
**characterised in that**
the third plurality (8) of the elementary modules is split up according to a partitioning of at least two sub-assemblies (32; 34; 36; 38) of module(s) (14₁, 14₂..., 14ₖ; 16₁, 16₂, ...16ₗ 18₁, 18₁, 18₂, ..., 18ₘ; 20₁, 20₂, ..., 20ₙ), each sub-assembly (32; 34; 36; 38) of module(s) containing one or more elementary module(s) (14₁, 14₂..., 14ₖ; 16₁, 16₂, ...16ₗ; 18₁, 18₁, 18₂, ..., 18ₘ; 20₁, 20₂, ..., 20ₙ) and a different monobloc mechanical structure (42, 44, 46, 48) in which are integrated the one or more elementary modules (14₁, 14₂..., 14ₖ; 16₁, 16₂, ...16_{l;} 18₁, 18₁, 18₂, ..., 18ₘ; 20₁, 20₂, ..., 20ₙ); and
at least two sub-assemblies (32, 34, 36, 38) of modules of the partitioning of the third plurality (8) are sub-assemblies of at least two modules, each defining a different islet of modules, and
the digital processing device contains a harness (52) of optical links (54, 56, 58, 62, 64, 66) for mutually interconnecting the sub-assemblies (32, 34, 36, 38) of modules whose interconnection lengths are compatible with interconnection runs between two interconnected islets (32, 34, 36, 38), said interconnection lengths being arranged so as to avoid, by sidestepping, one or more items of equipment external to the digital processing device, which are installed on the space platform and interposed between the two interconnected islets, and/or to distribute at least two interconnected islets over two heat exchange zones of the space platform that are separated by a separation distance of the scale of the size of the platform, at least one external interconnection length of the optical harness (52) between two islets of modules being comprised between 1 metre and 50 metres, preferably between 1 and 7 metres.

2. The digital processing device according to claim 1, wherein
the third plurality (8) of the elementary modules is split up according to a partitioning of at least two sub-assemblies of module(s) (32, 34, 36, 38), the partitioning containing at least two islets (32, 34, 36, 38),
the partitioning being arranged to distribute the mass and the thermal power of the digital processing device over at least two heat exchange zones (222, 224, 226, 228) of the space platform (202) which are separated by a separation distance of the scale of the size of the space platform (202).

3. The digital processing device according to any one of claims 1 to 2, wherein
the third plurality (8) of the elementary modules is split up according to a partitioning containing only islets (32, 34, 36, 38).

4. The digital processing device according to any one of claims 1 to 2, wherein
the throughput of the input ports and of the output ports lie between 6 Mb/s and 100 Mb/s, and/or
the number of input ports lies between 8 and 200, and
the number of output ports lies between 8 and 200, and/or
the number of modules lies between 2 and 100, and/or
the number of islets lies between 1 and 10.
